# EUROPEAN PATENT APPLICATION

(11) **EP 4 415 028 A1**
(43) Date of publication of application: **14.08.2024**
(21) Application number: 22878146.4
(22) Date of filing: 29.06.2022
(51) Int. Cl.: H01L 21/365, H01L 21/368

(54) **FILM FORMING APPARATUS AND METHOD FOR FORMING CRYSTALLINE SEMICONDUCTOR FILM USING SAME**

(30) Priority: 07.10.2021 JP 2021165618
(71) Applicant: SHIN-ETSU CHEMICAL CO., LTD., Tokyo 1000005 (JP); Shin-etsu Engineering Co., Ltd., Tokyo 101-0054 (JP)
(72) Inventor: HASHIGAMI, Hiroshi, Annaka-shi, Gunma 379-0195 (JP); KOJIMA, Muneyuki, Annaka-shi, Gunma 379-0127 (JP)
(74) Representative: Mooser, Sebastian Thomas
(86) International application number: PCT/JP2022/025860
(87) International publication number: WO 2023/058273

(57) **Abstract**

The present invention provides a film forming apparatus including an atomizer configured to atomize a raw material solution to generate a raw material mist, a carrier gas supplier configured to supply a carrier gas that carries the raw material mist, a mist supplier configured to supply a mixture gas in which the raw material mist and the carrier gas are mixed to a surface of a substrate, a stage configured to hold the substrate, a heater configured to heat the substrate, and an exhaust unit directly or indirectly connected to the stage through piping. Thus, a film forming apparatus that can form a crystalline semiconductor film with favorable crystal orientation stably and with high productivity, and a method of forming a crystalline semiconductor film are provided.

## Description

### TECHNICAL FIELD

The present invention relates to a film forming apparatus and a method of forming a crystalline semiconductor film using the same.

### BACKGROUND ART

Mist chemical vapor deposition (hereinafter also referred to as "mist CVD") is known as a method capable of forming various thin films on substrates at low temperatures and at atmospheric pressure. This technology has particularly drawn attention in that it can form crystalline semiconductor thin films useful for electronic device applications. Patent Document 1 discloses a method in which a raw material solution of gallium acetylacetonate complex dissolved in a mixture of hydrochloric acid and water is atomized into a mist and the mist is supplied to a sapphire substrate installed in a narrow space (fine channel) in a reactor to form an α-Ga₂O₃ film on the substrate held at 350°C to 500°C. Patent Document 2 discloses an example in which a raw material solution containing hydrobromic acid in an aqueous solution of gallium bromide is atomized into a mist and the mist is supplied to a sapphire substrate held at 550°C on a hot plate to form an α-Ga₂O₃ film. Patent Document 3 discloses a method of performing epitaxial growth on a β-Ga₂O₃ film substrate heated to 750°C, using an aqueous solution of gallium chloride and ammonium fluoride as a raw material.

### CITATION LIST

### PATENT LITERATURE

Patent Document 1: JP 2013-028480 A
Patent Document 2: JP 2020-107636 A
Patent Document 3: JP 2020-188170 A

### SUMMARY OF INVENTION

### TECHNICAL PROBLEM

As described above, the crystal thin film growth using mist CVD is characterized in that a raw material is supplied in the form of droplets to a substrate held at high temperatures. However, supply of droplets to the heated substrate causes a significant temperature gradient in the thickness direction of the substrate. As a result, as the diameter of the substrate increases, warpage and/or fractures of the substrate frequently occurs, causing significant deterioration in productivity. To cope with this, the temperature gradient is usually alleviated by reducing the amount of mist supply and/or the flow rate of carrier gas, but this method reduces the film growth rate and therefore has difficulty in improving the productivity.

The present invention is made to solve the above problem and is aimed to provide a film forming apparatus that can form a crystalline semiconductor film with favorable crystal orientation stably and with high productivity, and a method of forming a crystalline semiconductor film.

### SOLUTION TO PROBLEM

To achieve the object, the present invention provides a film forming apparatus including:
an atomizer configured to atomize a raw material solution to generate a raw material mist;
a carrier gas supplier configured to supply a carrier gas that carries the raw material mist;
a mist supplier configured to supply a mixture gas in which the raw material mist and the carrier gas are mixed to a surface of a substrate;
a stage configured to hold the substrate;
a heater configured to heat the substrate; and
an exhaust unit directly or indirectly connected to the stage through piping.

Such a film forming apparatus can stably hold a substrate and therefore can form a crystalline semiconductor film with favorable crystal orientation stably and with high productivity.

It is preferable that a pipe that directly or indirectly connects the stage and the exhaust unit through piping comprises any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, nickel alloy, and stainless steel, or a combination thereof.

Such a film forming apparatus can be robust against highly reactive raw materials or gases and can easily form a film stably and with high productivity.

It is preferable that the film forming apparatus further includes an abatement unit connected to the exhaust unit through piping.

Such a film forming apparatus can remove hazardous substances contained in the exhaust gas and therefore can stably maintain a vacuum in the pipe.

It is preferable that a pipe that connects the exhaust unit and the abatement unit through piping comprises any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, nickel alloy, and stainless steel, or a combination thereof.

Such a film forming apparatus can be more robust against highly reactive raw materials or gases and can easily form a film more stably and with high productivity.

It is preferable that the exhaust unit has a gas contact portion comprising any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, and nickel alloy, or a combination thereof.

Such a film forming apparatus can stably fix a substrate and therefore can form a film even more stably and with high productivity.

It is preferable that the film forming apparatus further includes a cooler at a pipe that directly or indirectly connects the stage and the exhaust unit through piping, the cooler being configured to cool the pipe.

In such a film forming apparatus, the degree of freedom in apparatus configuration and process conditions can be increased. Thus, the apparatus can stably form a crystalline semiconductor film of even higher quality.

The present invention further provides a method of forming a crystalline semiconductor film using the above film forming apparatus, the method includes the steps of:
placing the substrate on the stage;
fixing the substrate to the stage by vacuum sucking the substrate by the exhaust unit;
heating the substrate;
atomizing the raw material solution;
mixing the atomized raw material solution and the carrier gas to form the mixture gas; and
supplying the mixture gas to the substrate to perform film formation on the substrate.

With such a method, a crystalline semiconductor film with favorable crystal orientation can be formed stably and with high productivity.

It is preferable that the raw material solution has a pH set to 0.4 or more and 4.0 or less.

With such a method of forming a crystalline semiconductor film, desorption of metal elements does not become dominant, film growth is not inhibited, deposition of hydroxides of metals does not become significant, and defects due to the deposition is not introduced to the grown film and the quality of the film is not reduced.

It is preferable that a substrate having a main surface area of 15 cm² or more is used as the substrate.

In this manner, a crystalline semiconductor film with favorable crystal orientation can be formed with higher productivity.

In the step of fixing the substrate to the stage, it is preferable that interior of the pipe is set to a vacuum of 80 kPa or less.

With such a method of forming a crystalline semiconductor film, warpage due to thermal stress produced in the substrate can be sufficiently suppressed, and fracture of the substrate can be prevented.

### ADVANTAGEOUS EFFECTS OF INVENTION

According to the present invention, a film forming apparatus with high productivity that can stably form a crystalline semiconductor film with a large area and excellent crystal orientation can be provided. Furthermore, according to the present invention, a crystalline semiconductor film with a large area and excellent crystal orientation can be formed stably and with high productivity.

### BRIEF DESCRIPTION OF DRAWINGS

FIG. 1 is a schematic diagram illustrating an aspect of a film forming apparatus according to the present invention.
FIG. 2 is a schematic diagram illustrating an aspect of a substrate holder according to the present invention.
FIG. 3 is a schematic diagram illustrating another aspect of a substrate holder according to the present invention.

### DESCRIPTION OF EMBODIMENTS

As described above, there has been a demand for development of a film forming apparatus that can form a crystalline semiconductor film with favorable crystal orientation stably and with high productivity.

The inventors of the present invention have conducted elaborate studies on the above problem and found that provision of an exhaust unit directly or indirectly connected through piping to a stage holding a substrate results in a film forming apparatus that can form a crystalline semiconductor film with favorable crystal orientation stably and with high productivity. This finding has led to completion of the invention.

More specifically, the present invention provides a film forming apparatus including:
an atomizer configured to atomize a raw material solution to generate a raw material mist;
a carrier gas supplier configured to supply a carrier gas that carries the raw material mist;
a mist supplier configured to supply a mixture gas in which the raw material mist and the carrier gas are mixed to a surface of a substrate;
a stage configured to hold the substrate;
a heater configured to heat the substrate; and
an exhaust unit directly or indirectly connected to the stage through piping.

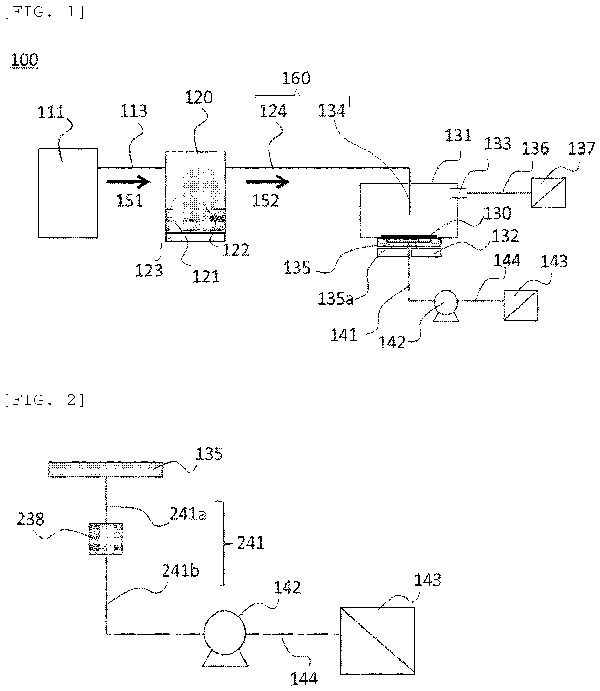

Although the present invention will be described in detail below with reference FIG. 1, the present invention is not intended to be limited to this.

### Film Forming Apparatus

A film forming apparatus of the present invention includes an atomizer, a carrier gas supplier, a mist supplier, a stage to hold a substrate, a heater, and an exhaust unit directly or indirectly connected to the stage through piping. The details will be described below.

FIG. 1 is a diagram illustrating an aspect of a configuration of the film forming apparatus suitably used in the present invention. The film forming apparatus 100 suitably used in the present invention includes an atomizer 123 in contact with a raw material container 120 to atomize a raw material solution 121 to generate a raw material mist 122, a film forming chamber 131 to supply the raw material mist 122 to a substrate 130 to form a film on the substrate 130, an abatement unit 137 to process an exhaust gas discharged from the film forming chamber 131 connected through a pipe 136, a stage 135 to hold the substrate 130, a heater 132 to heat the substrate 130 and the stage 135, an exhaust unit 142 such as a pump directly connected through piping to the stage 135 to fix the substrate 130 by suction under reduced pressure (vacuum suction), and an abatement unit 143 for processing the exhaust from the exhaust unit 142.

The film forming apparatus 100 further includes a carrier gas supplier 111. The carrier gas supplier 111, the raw material container 120, and the film forming chamber 131 are connected through a pipe 113 and a pipe 124. The raw material mist 122 is mixed with a carrier gas 151 in the raw material container 120 to form a mixture gas 152, which is then supplied to the film forming chamber 131 by a mist supplier 160.

### (Raw Material Solution)

The raw material solution 121 is not limited as long as it can be atomized into a mist. A solution or dispersion of a metal in the form of complex or salt in a solvent such as water or an organic solvent can be used.

In this case, it is preferable that an acid such as hydrochloric acid, hydrobromic acid, or hydriodic acid, or an alkali such as ammonia is added to the solvent to adjust the pH of the solvent to be used.

### (Atomizer)

The atomizer 123 of the raw material solution 121 is not limited as long as it can atomize or form droplets of the raw material solution 121, and may be any know means, but in the present invention, an atomizer using ultrasound is preferred. The mist or droplets obtained using ultrasound are preferred because they have an initial velocity of zero and float in the air. The mist or droplets are extremely suitable, because, for example, rather than being blown like spray, the mist can float in the air and transfer in the form of gas and therefore free from damage due to collision energy. The droplet size is not limited and may be approximately a few mm, preferably 50 um or less, and more preferably 0.1 to 10 µm.

### (Raw Material Container)

The raw material container 120 may be provided plurality of depending on the material from which a film is formed. In this case, the mixture gases 152 supplied from plurality of the raw material containers 120 to the film forming chamber 131 may be each independently supplied to the film forming chamber 131 or may be mixed in the pipe 124 or in a container for mixing (not illustrated) separately provided.

The raw material container 120 may additionally include a temperature controller (not illustrated) for directly or indirectly regulating the temperature of the raw material solution 121. The temperature of the raw material solution 121 is not limited that enables atomization, preferably 10°C to 90°C, more preferably 20°C to 50°C. In this way, a temperature drop at a film-formed surface of the substrate 130 is alleviated, enabling more favorable film formation. Temperatures of 90°C or lower can effectively suppress vaporization of the raw material mist 122, stably maintain the yield of film formation, and more stably suppress introduction of defects in the film surface.

The raw material container 120 may additionally include a not-illustrated replenisher to add the raw material solution 121. In this case, the replenisher to add the raw material solution 121 may further include a detector to directly or indirectly detect the weight or the liquid level of the raw material solution 121.

### (Carrier Gas Supplier)

The carrier gas supplier 111 supplies the carrier gas 151. The kind of carrier gas 151 is not limited. For example, an inert gas such as nitrogen or argon, as well as air, oxygen, ozone, or a reducing gas such as hydrogen or forming gas may be used, or a mixture of two or more of these gases may be used. The flow rate of the carrier gas may be set as appropriate according to the substrate size or the size of the film forming chamber, and for example, about 0.01 to 100 L/min.

The carrier gas supplier 111 may be an air compressor, a variety of gas cylinders, or a nitrogen gas separator, and may include a mechanism for controlling the flow rate of gas supply.

### (Film Forming Chamber)

The film forming chamber 131 is provided with a supply tube 134 coupled to the pipe 124 to supply the mixture gas 152 into the film forming chamber 131. For example, a quartz, glass, or resin tube can be used for the supply tube 134. An exhaust port 133 for exhaust gas may be provided at a location that does not affect a mist supply from the supply tube 134. The exhaust port 133 may be connected to the abatement unit 137 through the pipe 136. The pipe 136 or the abatement unit 137 may further include a regulator for regulating the flow rate of exhaust and/or the amount of outside air introduced. The abatement unit 137 is not limited as long as it can remove hazardous substances contained in the exhaust gas. For example, a wide variety of known techniques such as mist trap, wet scrubber, combustion abatement equipment, and bag filter can be employed.

The structure, material, and the like of the film forming chamber 131 are not limited. For example, a metal such as aluminum or stainless steel, soda glass, or borosilicate glass may be used, or when film formation is performed at higher temperatures, quartz, silicon carbide, aluminum oxide, or aluminum nitride may be used.

The film forming chamber 131 has a stage 135 at its bottom, and a substrate 130 is placed on the stage 135. The stage 135 includes a heater 132 to heat the stage 135 and thereby heat the substrate 130. The heating of the substrate 130 is adjusted as appropriate according to the raw material mist 122 used or the film formation conditions, and in general set to the range of 120°C to 800°C.

### (Mist Supplier)

The mist supplier 160 is not limited as long as it supplies the mixture gas 152 to a surface of the substrate 130. For example, the mist supplier 160 may be a combination of the pipe 124 and the supply tube 134.

### (Heater)

A known heater can be employed as the heater 132, and resistance heating, electromagnetic induction heating, or lamp heating can be used suitably.

### (Stage)

The material of the stage 135 can be selected as appropriate according to process conditions such as the acidity of raw materials used for film formation and heating temperatures. It is preferable that at least a portion of a surface of the stage 135 is made of nickel alloy, graphite, silicon carbide, aluminum oxide, aluminum nitride, or quartz, and when higher corrosion resistance against the raw material solution is required, silicon carbide, aluminum oxide, aluminum nitride, and quartz are more preferred. The nickel alloy refers to an alloy containing 50% or more of nickel.

The stage 135 may be a replaceable structure depending on the kind of raw material solution and/or process conditions. In this case, for example, the stage may be a stacked structure of a pedestal and an upper plate resting on the pedestal, and the substrate may be placed on the upper plate. In this case, the substrate and the upper plate may be simultaneously fixed by suction to the pedestal via through holes provided in the upper plate.

The stage 135 may further include a mechanism for transporting or rotating a substrate.

The stage 135 has a substrate-placed portion having a single or a plurality of suction holes 135a connecting a substrate-placed surface and a backside of the stage 135. The suction hole(s) 135a, the exhaust unit 142, and the abatement unit 143 are connected through a pipe 141 and a pipe 144. The substrate 130 is fixed onto the stage 135 by the exhaust unit 142 reducing the pressure of the interior of the suction hole(s) 135a and the pipe 141.

The substrate-placed surface of the stage 135 can have a shape suitable for the shape of the substrate 130 and may be a flat surface, have a curved portion, or have an uneven shape.

### (Pipes)

The pipes 113 and 124 are not limited as long as they have sufficient stability against the raw material solution 121 and the temperatures of the inside or outside of the film forming chamber 131. Pipes made of a wide variety of general resins such as polyethylene, polypropylene, polyvinyl chloride, silicon resin, urethane resin, and fluororesin, in addition to quartz, can be used.

Although not illustrated in the figures, a pipe that does not pass through the raw material container 120 from the carrier gas supplier 111 may be separately connected to the pipe 124, so that a diluent gas is further added to the mixture gas 152 to adjust the proportions of the raw material mist 122 and the carrier gas 151. The flow rate of the diluent gas can be set as appropriate and, for example, can be set to 0.1 to 20 times/min of that of the carrier gas. The diluent gas may be supplied, for example, to the downstream side of the raw material container 120. The diluent gas may be the same as or different from the carrier gas 151.

The pipes 141 and 144 can be selected as appropriate according to the kind of the raw material solution 121 and/or the temperature of the stage 135 in use. It is preferable that at least part of the pipes 141 and 144 is made of any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, nickel alloy, and stainless steel, or a combination thereof. This configuration prevents the pipes from being damaged even when a highly reactive raw material solution is used for film formation, thereby enabling the substrate to continue to be stably fixed.

When the stage 135 reaches a high temperature of 300°C or higher, it is preferable to use a heat-resistant material such as quartz glass, aluminum oxide, silicon carbide, aluminum nitride, nickel alloy, or stainless steel at least at a connection portion of the pipe 141 with the stage 135. This configuration enables heat insulation between the stage 135 and the pipe 141 or dissipation of heat from the stage 135, thereby increasing the degree of freedom of usable pipe materials and increasing the variety of apparatus designs.

### (Cooler)

To promote heat dissipation of the pipe 141 more actively, as illustrated in FIG. 2, a cooler 238 may be provided at a desired location in a pipe 241 that connects the stage 135 and the exhaust unit 142. The cooler 238 may employ a wide variety of known cooling methods and may be air cooling or water cooling. A metal block or heat dissipation fins may be used in combination, or heat dissipation may be promoted by adjusting the length or shape of the pipe 241 formed of the above heat-resistant material.

### (Exhaust Unit)

An ejector or vacuum pump is suitably used for the exhaust unit 142. The exhaust unit 142 preferably has a gas contact portion made of any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, and nickel alloy, or a combination thereof. This configuration prevents the equipment from being damaged even when a highly reactive raw material solution is used for film formation, thereby enabling the substrate to continue to be stably fixed.

The ultimate vacuum achieved by the exhaust unit 142 is not limited to the extent that the substrate 130 can be fixed stably. To hold the substrate 130 more stably, the ultimate vacuum is preferably 80 kPa or less, more preferably 40 kPa or less. The pipes 141 and 242 may be provided with a not-illustrated pressure gage to monitor the ultimate vacuum. In this case, the pressure gage may be the one that can output a signal according to measurements to an external instrument.

### (Abatement Unit)

As described above, it is preferable that the abatement unit 143 connected to the exhaust unit through piping is provided. In this case, the abatement unit 143 is not limited as long as it can remove hazardous substances contained in the exhaust gas sucked from the stage 135. For example, a wide variety of known techniques such as mist trap, wet scrubber, combustion abatement equipment, and bag filter can be employed. This configuration can remove hazardous substances contained in the exhaust gas and allows the vacuum in the pipes to be stably maintained.

FIG. 1 illustrates an aspect of the film forming apparatus 100 that includes separate abatement units 137 and 143, but the present invention is not limited thereto. The abatement units 137 and 143 may be a single unit for collective processing.

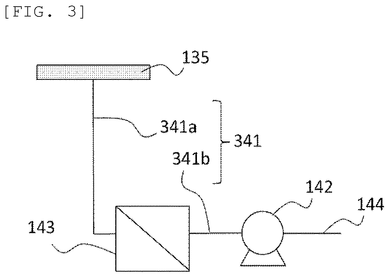

FIG. 1 and FIG. 2 illustrate an example of the aspect in which the abatement unit 143 processes the exhaust from the exhaust unit 142, but the present invention is not limited thereto. As illustrated in FIG. 3, the abatement unit 143 may be provided between the stage 135 and the exhaust unit 142 through a pipe 341a and a pipe 341b (pipe 341), and gas processed by the abatement unit 143 may be sucked by the exhaust unit.

### Method of Forming Crystalline Semiconductor Film

The present invention also provides a method of forming a crystalline semiconductor film using a film forming apparatus, the method includes steps of: placing the substrate on the stage; fixing the substrate to the stage by vacuum sucking the substrate by the exhaust unit; heating the substrate; atomizing the raw material solution; mixing the atomized raw material solution and the carrier gas to form the mixture gas; and supplying the mixture gas to the substrate to perform film formation on the substrate. More specifically, the method of forming a crystalline semiconductor film uses the above film forming apparatus of the present invention, in which a raw material solution is atomized into a mist, and the raw material solution in the form of a mist (raw material mist) is supplied to a substrate fixed by suction on the stage of the film forming apparatus to perform film formation on the substrate.

The substrate 130 is not limited as long as it can support a crystalline semiconductor film to be formed. In the present invention, the substrate 130 is preferably shaped like a plate such as a flat plate or a disc, but the present invention is not limited thereto, and may be shaped like a rod, cylinder, prism, tube, or ring. The material of the substrate 130 is not limited and may be a known material or may be an organic compound or an inorganic compound. Examples of the material include polysulfone, polyethersulfone, polyphenylene sulfide, polyetheretherketone, polyimide, polyetherimide, fluororesin, metals such as iron, aluminum, stainless steel, and gold, quartz, glass, calcium carbonate, gallium oxide, and ZnO. In particular, single crystals are preferred, and it is preferable to use single crystals of GaN, SiC, lithium tantalate, lithium niobate, silicon, sapphire, and alpha-gallium oxide to obtain a crystalline semiconductor film with favorable crystal orientation.

A substrate with a crystalline semiconductor film-formed surface having an area (main surface area) of preferably 15 cm² or more, more preferably 20 cm² or more, can be suitably used. Furthermore, a substrate having a thickness of preferably 50 to 5000 µm, more preferably 100 to 2000 um can also be suitably used. With a thickness of 50 um or more, it is easy to support a crystalline semiconductor film. With a thickness of 5000 um or less, a temperature drop of the substrate due to the raw material mist is not significant and the crystal orientation of the crystalline semiconductor film is not reduced. With a main surface area of 15 cm² or more, a crystalline semiconductor film with favorable crystal orientation can be formed with higher productivity. The upper limit of the main surface area is, for example, but not limited to, 700 cm² or less.

In the step of placing the substrate on the stage, the method of placing the substrate on the stage is not limited, and a known method can be used.

In the step of fixing the substrate 130 by suction, the substrate 130 is placed on the substrate-placed surface of the stage 135, and the exhaust unit 142 forms a vacuum in the suction hole(s) 135a closed by the substrate 130 to fix the substrate 130 to the stage 135. The vacuum here is adjusted as appropriate according to film formation conditions and characteristics of the substrate and may be usually 80 kPa or less, more preferably 40 kPa or less. With 80 kPa or less, warpage due to thermal stress produced in the substrate 130 can be suppressed sufficiently and fracture of the substrate can be prevented. The lower limit of the vacuum is, for example, but not limited to, 5 kPa or more.

In the step of heating the substrate, the heating method is not limited and a known method can be used. It is particularly preferable to heat the stage. Further, the heating temperature is not limited.

In the step of atomizing the raw material solution, the method of atomizing the raw material solution is not limited, and a known method can be used. It is preferable to use ultrasound.

A solution or dispersion of a metal in the form of complex or salt in an organic solvent or water can be used as the raw material solution. In this case, it is preferable that an acid such as hydrochloric acid, hydrobromic acid, or hydriodic acid, or an alkali such as ammonia is added to the solvent such as an organic solvent or water to adjust the pH of the solvent to be used. In this case, it is preferable that the pH of the raw material solution is set to preferably 0.4 to 4.0, more preferably 0.8 to 2.0. With a pH of 0.4 or more, desorption of metal elements does not become dominant, and film growth is not inhibited. With a pH of 4.0 or less, deposition of hydroxides of metals does not become significant, defects due to the deposition is not introduced to the grown film, and the quality of the film is not reduced.

Examples of the form of salt include halide salts such as metal chloride salts, metal bromide salts, and metal iodide salts. A salt solution in which the above metal is dissolved in a hydrogen halide such as hydrochloric acid, hydrobromic acid, or hydriodic acid can also be used. Examples of the form of complex include acetylacetone complexes, carbonyl complexes, ammine complexes, and hydride complexes. An acetylacetonate complex can also be formed by mixing acetylacetone with the above salt solution.

The metal content in the raw material solution is not limited and can be set as appropriate according to the purpose. The metal content is preferably 0.001 mol/L or more and 2 mol/L or less, more preferably 0.01 mol/L or more and 0.7 mol/L or less.

The raw material solution may also contain a dopant. For example, when a gallium oxide film is doped, an n-type dopant such as tin, silicon, germanium, titanium, zirconium, vanadium, or niobium, or a p-type dopant such as copper, silver, cobalt, iridium, rhodium, magnesium, or nickel is used as the dopant.

In the step of mixing the atomized raw material solution and the carrier gas to form a mixture gas, the method of mixing the atomized raw material solution and the carrier gas to form a mixture gas is not limited, and a known method can be used. The kind of carrier gas is not limited. For example, an inert gas such as nitrogen or argon, as well as air, oxygen, ozone, or a reducing gas such as hydrogen or forming gas may be used, or a mixture of two or more of these gases may be used. The flow rate of the carrier gas may be set as appropriate according to the substrate size or the size of the film forming chamber, and for example, 0.01 to 100 L/min.

In the step of supplying the mixture gas to the substrate to perform film formation, the method of supplying the mixture gas to the substrate and the method of performing film formation are not limited, and known methods can be used.

### EXAMPLE

Hereinafter, the present invention will be specifically described with reference to Examples and Comparative Examples. However, the present invention is not limited thereto.

### (Example 1)

### Apparatus

In the film forming apparatus in FIG. 1, a nitrogen gas cylinder was used as the carrier gas supplier 111, to which the raw material container 120 made of borosilicate glass was connected using the pipe 113 made of PFA. The film forming chamber 131 made of quartz was prepared, and the supply tube 134 made of quartz and the raw material container 120 were connected using the pipe 124 made of PFA. The exhaust port 133 of the film forming chamber 131 was connected to a scrubber (abatement unit 137) using the pipe 136 made of polyvinyl chloride. The stage 135 was made of silicon carbide, and a resistive heater was installed as the heater 132 of the stage 135 under the stage 135. The stage 135 was connected to a pump (Chemker 410 available from Rocker Scientific Co., Ltd.) that was the exhaust unit 142 having a gas contact portion of PFA, using the pipe 141 made of Hastelloy. Furthermore, a mist trap with a PFA membrane filter was connected to the pump as the abatement unit 143 for the exhaust from the pump, using the pipe 144 made of PFA.

### Preparation of Substrate

A c-plane sapphire substrate with a diameter of about 10 cm and a thickness of 0.7 mm was placed on the stage and fixed by suction using the pump. The stage was then heated with the heater and the stage temperature was maintained at 500°C. The pressure inside the pipe 141 at that time was measured and determined to be 28 kPa.

### Preparation of Raw Material Solution

Gallium acetylacetonate was dissolved in an acid solution of hydrochloric acid and pure water to prepare a solution with a gallium concentration of 0.05 mol/L as the raw material solution 121. The pH of the solution was measured and determined to be 0.9.

### Atomization of Raw Material

Subsequently, the raw material solution 121 was charged into the raw material container 120, and the raw material solution 121 was atomized by applying ultrasonic vibrations of 2.4 MHz.

### Film Formation

Nitrogen gas was introduced from the nitrogen gas cylinder at 5 L/min into the raw material container 120, and the generated mixture gas was supplied to the film forming chamber 131 to perform film formation.

Thereafter, a similar procedure was repeated to prepare a total of 10 samples.

The film formed on the substrate was determined by XRD (Rigaku SmartLab) to be α-Ga₂O₃.

Thereafter, for all of the samples, the rocking curve was further measured, and the full width at half maximum (FWHM) was evaluated.

### (Comparative Example 1)

Film formation was performed in the same way as in Example 1 except that suction fixing of the substrate was not performed.

Thereafter, a similar procedure was repeated to perform film formation in total 10 times, in four of which the substrates were fractured.

For six samples remaining not fractured, the film formed on the substrate was determined by XRD to be α-Ga₂O₃.

Thereafter, for the prepared six samples, the rocking curve was further measured, and the full width at half maximum (FWHM) was evaluated.

### (Example 2) Pipe Cooling

In the film forming apparatus in FIG. 1, the piping from the stage to the pump had the configuration in FIG. 2, a heat sink was attached to the pipe 241a made of Hastelloy, and the pipe 241a was connected to the pump using the pipe 241b made of PFA.

Except for the above, film formation and evaluation were conducted in the same way as in Example 1.

The average values of the rocking curve FWHM of the films obtained in Examples 1 and 2 and Comparative Example 1 are listed in Table 1. In Examples, crystalline semiconductor films with high crystal orientation were stably obtained, whereas the crystal orientation of the crystalline semiconductor film in Comparative Example was significantly reduced. The reason for this is presumably that heating of the substrate was insufficient and the temperature of the film-formed surface was reduced, because the substrate was not fixed in Comparative Example.

**[Table 1]**

| | Rocking curve FWHM [sec] |
|---|---|
| Example 1 | 9.7 |
| Example 2 | 9.4 |
| Comparative Example 1 | 45.7 |

### (Reference Example 1)

An aqueous hydrochloric acid solution with a pH of 0.9 was prepared by mixing only hydrochloric acid with pure water.

The aqueous hydrochloric acid solution was then charged into the raw material container 120 of the film forming apparatus used in Example 1 and further atomized.

A sapphire substrate with a diameter of about 10 cm and a thickness of 0.7 mm was then placed on the stage 135 and fixed by suction using the pump. Then, the stage was heated with the heater and the stage temperature was maintained at 500°C.

Nitrogen gas was then introduced at 5 L/min into the raw material container 120, and the generated mixture gas was supplied to the film forming chamber 131.

This state was held for a total of 1000 hours, and the pressure in the pipe 141 in this duration was measured and was constant at 2812 kPa.

### (Reference Example 2)

An experiment and measurement of the pressure in the pipe 141 were conducted in the same way as in Reference Example 1, except that the stage 135 and the pump were connected using the pipe 141 made of iron. The pressure in the pipe 141 was increased to 84 kPa after 800 hours. Corrosion of the pipe 141 was found.

The above results suggested that the present invention can produce crystalline semiconductor films of higher quality than conventional technologies stably and with high productivity.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A film forming apparatus comprising:
an atomizer configured to atomize a raw material solution to generate a raw material mist;
a carrier gas supplier configured to supply a carrier gas that carries the raw material mist;
a mist supplier configured to supply a mixture gas in which the raw material mist and the carrier gas are mixed to a surface of a substrate;
a stage configured to hold the substrate;
a heater configured to heat the substrate; and
an exhaust unit directly or indirectly connected to the stage through piping.

2. The film forming apparatus according to claim 1, wherein a pipe that directly or indirectly connects the stage and the exhaust unit through piping comprises any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, nickel alloy, and stainless steel, or a combination thereof.

3. The film forming apparatus according to claim 1 or 2, further comprising an abatement unit connected to the exhaust unit through piping.

4. The film forming apparatus according to claim 3, wherein a pipe that connects the exhaust unit and the abatement unit through piping comprises any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate, polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, nickel alloy, and stainless steel, or a combination thereof.

5. The film forming apparatus according to any one of claims 1 to 4, wherein the exhaust unit has a gas contact portion comprising any one of polyethylene, polypropylene, polyvinyl chloride, polystyrene, polyvinyl acetate, urethane resin, fluororesin, acrylonitrile butadiene styrene resin, acrylic resin, polyamide, polyimide, polyamideimide, nylon, acetal resin, polycarbonate, polyphenylene ether, polyester, polyethylene terephthalate, polybutylene terephthalate,
polyolefin, polyphenylene sulfide, polysulfone, polyethersulfone, polyarylate, polyetheretherketone, natural rubber, butadiene rubber, styrene rubber, butyl rubber, ethylene propylene rubber, nitrile rubber, acrylic rubber, urethane rubber, silicone rubber, fluororubber, soda glass, borosilicate glass, quartz glass, silicon carbide, aluminum nitride, aluminum oxide, and nickel alloy, or a combination thereof.

6. The film forming apparatus according to any one of claims 1 to 5, further comprising a cooler at a pipe that directly or indirectly connects the stage and the exhaust unit through piping, the cooler being configured to cool the pipe.

7. A method of forming a crystalline semiconductor film using the film forming apparatus according to any one of claims 1 to 6, the method comprising steps of:
placing the substrate on the stage;
fixing the substrate to the stage by vacuum sucking the substrate by the exhaust unit;
heating the substrate;
atomizing the raw material solution;
mixing the atomized raw material solution and the carrier gas to form the mixture gas; and
supplying the mixture gas to the substrate to perform film formation on the substrate.

8. The method of forming a crystalline semiconductor film according to claim 7, wherein the raw material solution has a pH set to 0.4 or more and 4.0 or less.

9. The method of forming a crystalline semiconductor film according to claim 7 or 8, wherein a substrate having a main surface area of 15 cm² or more is used as the substrate.

10. The method of forming a crystalline semiconductor film according to any one of claims 7 to 9, wherein in the step of fixing the substrate to the stage, pipe interior is set to a vacuum of 80 kPa or less.
